# EUROPEAN PATENT SPECIFICATION

(11) **EP 1 163 696 B1**
(45) Date of publication and mention of the grant of the patent: **04.08.2010**
(21) Application number: 00906825.5
(22) Date of filing: 01.02.2000
(51) Int. Cl.: H01L 21/335, H01L 29/772, H01L 29/24

(54) **A LATERAL FIELD EFFECT TRANSISTOR OF SiC, A METHOD FOR PRODUCTION THEREOF AND A USE OF SUCH A TRANSISTOR**
LATERALER SiC-BASIERTER FELDEFFEKTTRANSITOR, DESSEN HERSTELLUNGSVERFAHREN UND DER GEBRAUCH EINES SOLCHEN TRANSISTORS
TRANSISTOR A EFFET DE CHAMP LATERAL EN SiC, SON PROCEDE DE FABRICATION ET SON UTILISATION COMME TRANSISTOR

(30) Priority: 03.02.1999 SE 9900358
(43) Date of publication of application: 19.12.2001
(73) Proprietor: Cree Sweden AB, 164 40 Kista (SE)
(72) Inventor: HARRIS, Christopher, S-191 72 Sollentuna (SE); KONSTANTINOV, Andrei, S-175 23 Järfälla (SE)
(74) Representative: Olsson, Jan
(86) International application number: PCT/SE2000/000192
(87) International publication number: WO 2000/046850

(56) References cited:
- EP-A1- 0 620 599
- WO-A1-99/45594
- WO-A2-97/36313
- US-A- 5 925 895

## Description

### TECHNICAL FIELD OF THE INVENTION PRIOR ART

The present invention relates to the field of lateral field effect transistors of SiC for high switching frequencies.

"High switching frequencies" means here frequencies above 1 MHz. Such transistors may be used in for instance power microwave applications in for example base stations for mobile telephones, radars and microwave ovens.

High frequency field effect transistors of this type require short gate electrodes in order to increase on-state channel current, minimise the carrier transit time in the channel and the gate capacitance. Shorter gate electrodes will therefore result in higher power and higher operation frequency. On the other hand, undesirable short-channel effects become significant as the gate length is decreased. Transistors with very short gates often do not show saturation in drain current with increasing drain bias, and a continual increase in drain current with increasing the drain bias is observed instead. This occurs because of the channel length modulation by the drain bias. Furthermore, in the extreme case a parasitic bipolar transistor can be turned on at a high drain bias, in which the source and drain act as the collector and emitter of the parasitic transistor, and the layer next to the channel layer, which is a substrate or buffer layer, is then the base. This effect may not be particularly significant for low power high frequency transistors, but it increasingly dominates the performance of high power transistors, in which the drain bias should be as high as possible in order to increase the total power.

Silicon carbide has, as a material for high frequency power transistor applications a number of advantages with respect to for instance Si. It has a high breakdown field, which results in a possibility to have shorter carrier transit times, a high saturation drift velocity and a high thermal conductivity.

A transistor of the type defined in the introduction is known through for instance US 5 270 554, which describes a high frequency field effect transistor with a lateral n-type channel. A channel of n-type conductivity is preferred, because the mobility of free electrons is considerably higher than valence-band holes in SiC. This transistor already known has a conductive substrate, a p-type buffer layer on top thereof, an n-type channel layer and highly doped contact regions formed in order to decrease the resistance of the drain and source region layers, as well as to minimise the contact resistance of these layers. The buffer layer of this transistor has to be low-doped and thick in order to block high voltages, minimise high-frequency active losses due to conductance and minimise reactive losses due to internal capacitances. This type of design is particularly prone to short-channel effects and a parasitic bipolar transistor turns on at large drain bias, said buffer layer functioning as the base of such a bipolar transistor. Such effects may be suppressed by increasing the gate length, but that would deteriorate the on-state current and high-frequency performance.

Accordingly, lateral field effect transistors of SiC for high switching frequencies experience undesirable short-channel effects if a short gate electrode is formed. The values of gate length, which can be achieved using currently available pattern definition tools are considerably below those, which are required for blocking a high voltage, which means that such high frequency transistors do not utilise the material potential to the full extent.

A similar transistor, but of the vertical type is known through WO 97 36313 A2.

### SUMMARY OF THE INVENTION

The object of the present invention is to provide a lateral field effect transistor of the type defined in the introduction, which has an increased operation speed and may be operated at a higher power than such transistors already known.

This object is according to the invention obtained by providing such a transistor with the features according to claim 1.

Such a highly doped p-type base layer will first of all block the extension of the depleting region from the source region layer to the drain region layer. In a structure like this the electric field will be entirely blocked by the base layer, so that a parasitic bipolar transistor can not be formed, even if the lateral length of the gate is very small. Furthermore, the p-n-junction so created can block higher voltages than a Schottky barrier, resulting in an increase of the possible power. The reason for having the base layer restricted to not extend to the drain region layer is that this will keep the drain-to-gate capacitance low.

According to a preferred embodiment of the invention the doping concentration of said base layer decreases either gradually or step-wise over at least a part of the lateral extension thereof in the lateral direction from the source region layer towards the drain region layer. Although a high doping concentration of the p-base layer is preferable from the viewpoint of reliable electrical grounding to the source region layer, the considerations of obtaining a high avalanche breakdown voltage for the junction between the base layer and the channel layer may impose a different requirement. A sharp curvature or an edge of a highly doped region will result in an electric field concentration and decrease the breakdown voltage. The decrease according to this embodiment will result in a highly doped region of the base layer providing sufficient conductance to lead the AC current to the source, whereas the portion with a lower doping will make possible an increase in the breakdown voltage.

According to another preferred embodiment of the invention the doping concentration of said base layer is above 10¹⁸ cm⁻³, more preferred above 10¹⁹ cm⁻³ and most preferred above 10²⁰ cm⁻³. It has been realised that it is preferable to form the base layer as highly doped as possible for the following reasons: a high-frequency electric field may penetrate into a bulk conductive material for frequencies above the dielectric relaxation frequency. If this field penetration indeed occurs in a transistor structure of this type the base layer can no longer block the high frequency electric field, and it will therefore not function properly. Said dielectric relaxation frequency is proportional to the conductivity of the material. Secondly, high frequency losses due to conduction will detoriate the transistor performance. For a particular transistor structure said penetration can potentially occur at frequencies, which are a few orders of magnitude lower than the dielectric relaxation frequency depending on device configuration. Accordingly, it is preferable to form the base layer as highly doped as possible, up to the solubility limit, which for for example aluminium in SiC is in the range 10²⁰-10²¹ cm⁻³. Such a high doping provides better grounding of the high-frequency voltage induced at the base layer, and the ohmic contact resistance of the base layer will also be improved thereby. On the other hand, lower doping levels may be more convenient from viewpoint of manufacturing process, so that a compromise solution will be used.

According to another preferred embodiment of the invention said base layer is doped with Al. It has been realised that aluminium is a preferred dopant type, because aluminium acceptors have a lower thermal activation energy than for instance boron and therefore a higher conductivity can be obtained for aluminium-doped layers.

According to another preferred embodiment of the invention the transistor comprises an insulation layer arranged between the gate electrode and the channel layer. Such a MOS- or MIS-field effect transistor may have better high temperature capabilities than a transistor in which the gate electrode is arranged next to the channel layer, so-called metal-semiconductor FETs (MESFETs), and can be advantageously used for high temperature electronic applications.

According to another preferred embodiment of the invention at least a part of the source region layer is arranged next to the base layer for forming a pn-junction therebetween. Such an immediate contact of the highly doped n-type source region layer and the highly doped p-type base layer is advantageous, since the pn-junction so formed has a high capacitance which provides an efficient sink of the high frequency signal to the source.

According to another preferred embodiment of the invention the transistor comprises a trench, and the base layer and the source region layer are arranged on top of each other as seen in the lateral direction on a substantially vertical wall of the trench, which makes it possible to form a pn-junction with a high capacitance and short the AC component of the voltage induced at the base layer to the source and at the same time arrange the gate electrode with no lateral distance to the source region layer.

According to another preferred embodiment of the invention the transistor comprises a vertical trench having the source region layer formed on the substantially vertical walls thereof, and the orientation of the vertical walls are chosen to substantially align with the crystal planes of the SiC. This is preferable for the following reason. A transistor of this type is preferably obtained by using lateral epitaxial growth, which involves material-specific issues related to silicon carbide crystal symmetry. The growth rate and crystal habit for lateral epitaxy will depend on the orientation of the crystal planes forming said trench walls. It is therefore preferable to form the trenches for lateral epitaxy as straight lines of specific orientation rather than of circular or a polygonal configuration. Furthermore, a preferred configuration of a high power high frequency transistor.is a linear array of source, drain, channel and gate regions. Interconnection of either sources or drains or gates is performed using air bridging or through hole technology in order to minimise resistance and inductance associated with the metal contacts. For a linear array an n-type source region layer has to be used as source region layer for two channels simultaneously. It is therefore preferable that the crystal planes forming the opposite sides of the trenches for lateral epitaxy are crystallographically symmetrical.

The invention also comprises a method for producing a lateral field effect transistor of SiC for high switching frequencies comprising the steps defined in the independent claim 16. Such a method enables the production of a lateral field effect transistor with the preferred features discussed above in a comparatively simple way and accordingly to a cost making the production thereof commercially interesting.

One advantage of a field effect transistor design employing such a lateral epitaxial growth technique is, as already mentioned, the possibility to minimise the source resistance by positioning the gate very close to or even overlapping the edge of the source region layer.

The invention also relates to a use of a transistor according to Claim 1 for switching high frequencies above 1 MHz, preferably above 1 GHz, and in which it switches high frequency signals with a power above 1 W. A lateral field effect transistor of SiC according to the invention is well suited for switching such high frequencies in combination with high powers, since the arrangement of the base layer according to the invention makes it possible to benefit from the excellent properties of SiC with respect to high breakdown voltage and high thermal conductivity when making the gate electrode short.

Preferred uses of a transistor according to Claim 1 are furthermore in base stations for mobile telephones, in radars, in microwave ovens and in generating gas plasmas.

Further advantages and advantageous features of the invention appear from the following description and the other dependent claims.

### BRIEF DESCRIPTION OF THE DRAWINGS

With reference to the appended drawings, below follows a specific description of preferred embodiments of the invention cited as examples.

In the drawings:
- Fig 1: is a schematic cross-section view of a lateral field effect transistor of SiC according to the prior art,
- Fig 2: is a schematic cross-section view of a lateral field effect transistor with a highly doped p-type base layer arranged next to the channel layer,
- Fig 3: is a schematic cross-section view of a lateral field effect transistor according to a first preferred embodiment of the invention,

- Fig 4: is a cross-section view illustrating the step of producing the base layer in the transistor according to fig 2,
- Figs 5-9: are schematic cross-section views illustrating different steps of a method according to the invention for pro- ducing the transistor shown in fig 3,
- Fig 10: is a schematic cross-section view of a lateral field effect transistor according to a second preferred embodiment of the invention, and
- Figs 11-15: are schematic cross-section views illustrating different steps of a method for producing the transistor according to fig 10.

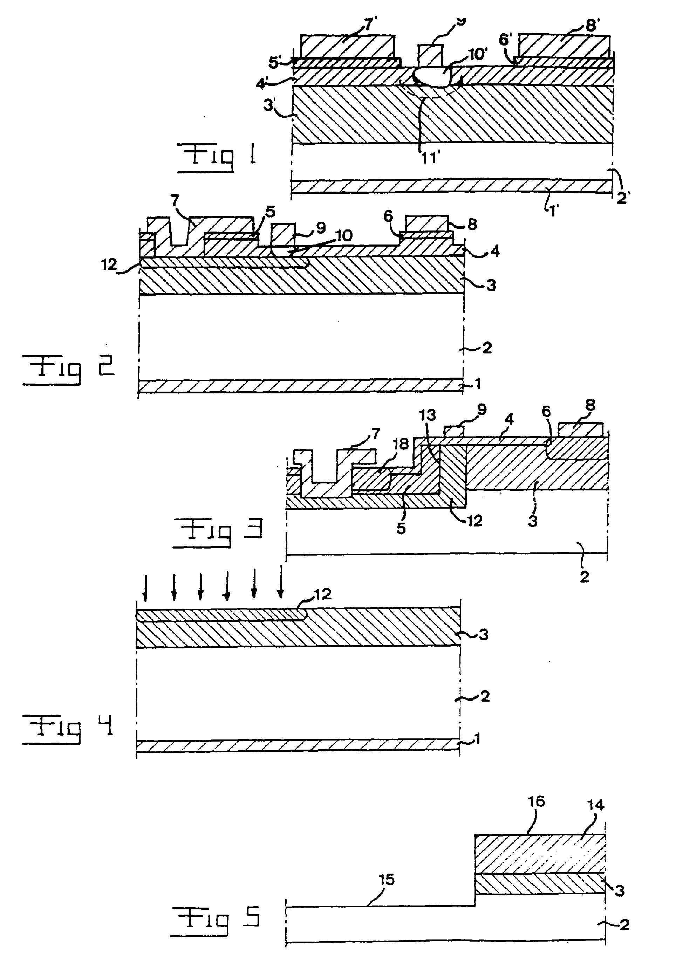

The transistor shown in fig 1 belongs to the prior art and has the following layers of SiC on top of a back side metalization layer 1': a semi-insulating substrate layer 2', a p-type buffer layer 3' and an n-type channel layer 4'. The buffer layer is present to minimise the effect of the deep centres present in the semi-insulating substrate on carrier transport. The doping level of the buffer layer should be low to keep high frequency losses at a low level. The transistor further comprises a source region layer 5' and a drain region layer 6' laterally spaced and highly doped n-type and arranged on top of the channel layer 4'. A source contact 7' and a drain contact 8' are arranged on these layers. The transistor also comprises a gate electrode 9' arranged on top of the channel layer 4' between the source region layer 5' and the drain region layer 6'. When a voltage is applied between the source contact and the drain contact a current may flow in the channel layer 4' between these two contacts as controlled by the gate electrode 9'. The gate electrode 9' will control said current by the potential applied thereon. Upon applying a positive potential of a certain magnitude a depletion region 10' will form in the channel layer extending to the buffer layer 3', which means that the current flow will be blocked and the switch will be open or in the off-state. When no voltage forming such a depletion region is applied to the gate electrode the channel will be continuous and current will flow between the two contacts 7' and 8' and the transistor will be closed or in the on-state. The transistor is able to be switched with a high frequency through changing the potential of the gate electrode 9'. As already discussed in detail above, it is desirable to make the gate electrode 9' short as seen in the lateral direction, with however the result that in the extreme case a parasitic bipolar transistor can be turned on at a high drain bias, in which the source region layer 5' act as the collector and the drain region layer 6' act as the emitter of the transistor, while the buffer layer 3' forms the base 3'. When such a parasitic bipolar transistor is created the lateral field effect transistor can no longer be turned off by the gate electrode 9', and the transistor will accordingly fail to function properly. It is illustrated by the dashed line 11' how such a parasitic bipolar transistor may be turned on. In the practice, this means that the gate electrode of such a prior art transistor will be made with a larger lateral extension than desired so as to avoid such a failure, but this will then lead to longer carrier transit time of the channel, a higher gate capacitance and a higher on-state resistance leading to increased losses.

Another transistor is show in fig 2. The same reference numerals as those used for the prior art transistor in fig 1 will be used hereafter for the transistors according to the different embodiments of the invention. The main difference between the transistor according to fig 2 and the transistor according to fig 1 is that a highly doped p-type base layer 12 is arranged next to the channel layer 4 overlapping the gate electrode 9 and at a lateral distance to the drain region layer 6. The base layer is shorted to the source region layer 5 by the metal source contact 7.

The base layer 12 is preferably doped up to the solubility limit for the reasons mentioned above, and this is for aluminium as dopant in SiC in the range 10²⁰-10²¹ cm⁻³. However should lower doping levels be more convenient from the viewpoint of the manufacturing process used, the doping concentration should in any case be above 10¹⁸ cm⁻³ and more preferably above 10¹⁹ cm⁻³.

The transistor shown in fig 2 may be provided with a gate electrode 9 having a very short length, quite possibly as short as 0,2-0,3 µm, without any risk of a formation of a parasitic bipolar transistor as described above. This is due to the fact that the electric field between the source and the drain will in the off-state of the transistor be entirely blocked by the highly doped base layer, so that the parasitic bipolar transistor can not be formed, even if the active gate length is very small. The high p-type doping of the base layer is required first of all because it should block the extension of the depletion region from the source to the drain. The lateral extension of the base layer is confined so that it will not extend underneath the drain region layer 6, which is required in order to keep a low drain-to-gate capacitance. Moreover, it is only necessary that the base layer 12 partially overlap the gate electrode.

It is preferred that the doping concentration of the base layer 12 decreases either gradually or step-wise in the lateral direction from the source region layer towards the drain region layer for the reasons mentioned further above. Furthermore, aluminium is a preferred dopant type for the base layer, since aluminium acceptors have a low thermal activation energy in SiC, so that a high conductivity can be obtained.

The positioning of the gate electrode 9 very close to the edge of the source region layer 5 minimises the source resistance and will improve the on-state performance of the transistor. The transistor according to fig 2 will be produced by starting to grow a low-doped (3 x 10¹⁵ cm⁻³), 0,75 µm thick p-type buffer layer 3 on top of a semi-insulating substrate layer 2, preferably by using Chemical Vapor Deposition (CVD). A suitable mask not shown in fig 4 is then applied on the buffer layer and an aperture is patterned in the mask, whereupon Al ions are implanted through said aperture for forming a highly doped p-type base layer 12 of a box-type profile with a depth of 0,4 µm as schematically illustrated

in fig 4. The doping level of the base layer will be 3 x 10¹⁹ cm⁻³. For this Al ions are implanted with for example energies of 40, 100, 170 and 300 keV and doses of 1,3 x 10¹⁴ cm⁻², 2,1 x 10¹⁴ cm⁻², 2,7 x 10¹⁴ cm⁻² and 6,7 x 10¹⁴ cm⁻², respectively. Then the mask is removed and the Al ions are activated by annealing at an anneal temperature not less than 1 700°C. After that an n-type channel layer is epitaxially grown on top of the base layer and the buffer layer. The thickness of this layer will be approximately 0,3 µm and it will be doped with nitrogen to a concentration of 5 x 10¹⁷ cm⁻³. A source region layer and a drain region layer of a thickness of 0,15 µm and a concentration of nitrogen of 1 x 10¹⁹ cm⁻³ are epitaxially grown on top of the channel region layer at laterally spaced positions with the drain region layer laterally spaced with respect to the base layer. This is in practice obtained by growing one layer on top of the channel region layer and then depositing a mask thereon and patterning the mask so that the source region layer and the drain region layer are defined. A gate electrode 9 is then applied on top of the channel layer at least partially overlapping the base layer, and the source metal contact 7 and the drain metal contact 8 are applied on the source region layer and the drain region layer, respectively, in which the former is applied so that it shorts the base layer to the source region layer. These are the most important steps of the method for producing the lateral field effect transistor according to fig 2, but the method also includes further conventional steps obvious to a man with ordinary skill in the art. Values of doping concentration and feature size are given as an illustration only, exact figures result from a more detailed specification of power and frequency response required.

### Detailed description of preferred embodiments of the invention.

A transistor according to a first preferred embodiment of the invention is illustrated in fig 3, and this is formed partially by lateral epitaxy as will be described further below. This embodiment differs from that shown in fig 2 primarily by the fact that the base layer 12 and the source region layer 5 are arranged in immediate contact with each other, the source region layer extending laterally under the channel layer (4) whereby the gate electrode 9 is arranged very close to the source region layer. The pn-junction 13 formed between the base layer and the source region layer has a high capacitance, which provides an efficient sink of the high frequency signal to the source. An ohmic contact 7 to the base layer must in this case only provide sink of the DC component of the current flowing through the base layer. The DC component of the base layer current is very small because the pn-junction between the base layer and the channel layer is reverse biased under normal operation conditions. The ohmic contact shorting the base layer to the source region layer may be positioned at a large distance from the channel without any deterioration of device performance. In certain cases no special shorting contact is required at all to short the DC base layer current component to the source region layer, and if the substrate and the buffer layer are conductive the DC component is shorted to the source through the buffer layer, and the patent claim definition "said base layer being shorted to the source region layer" should be interpreted to also cover this case. It is an additional advantage to form either the base layer or the source region layer degenerately doped so as to form a tunnel diode , i.e. a diode with tunneling properties, at their interface resulting in a tunnel current and a high junction capacitance automatically shorting the base layer to the source region layer.

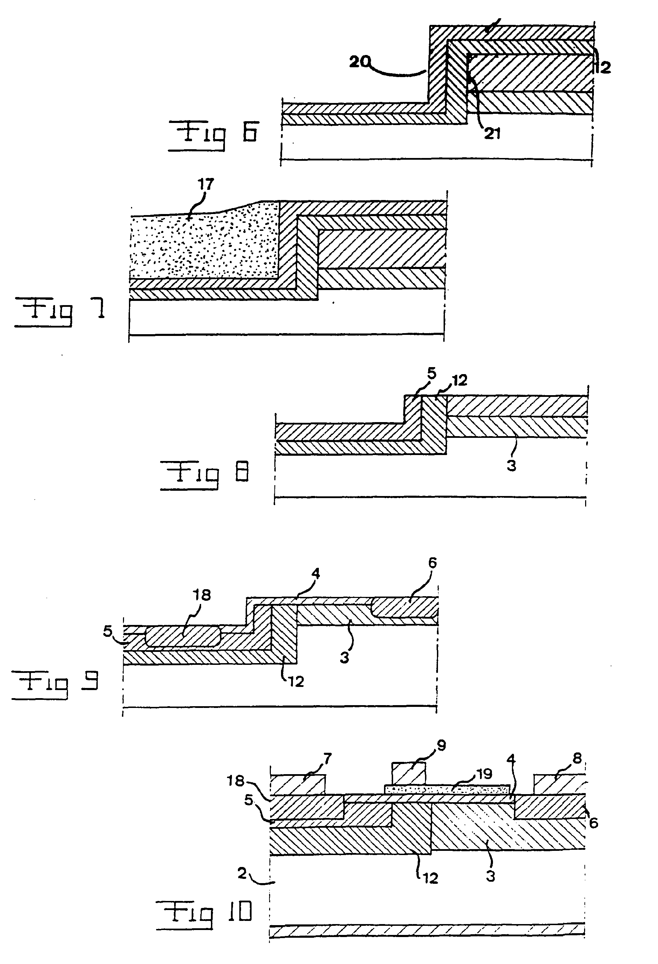

It will now with reference to fig 5-9 be briefly described how a transistor according to the preferred embodiment shown in fig 3 may be produced according to a preferred method. The method is started by epitaxially growing by CVD on top of a substrate layer 2, a p-type buffer layer 3 and an n-type layer 14. A mesa etch is then carried out through the two layers epitaxially grown for forming a step or trench 20 (see fig 5) with a lower first portion 15 with the substrate exposed and an upper second portion 16 with said n-type layer 14 on top. A highly doped p-type base layer 12 and a highly doped n-type source region layer 5 are after that epitaxially grown on top of the etched mesa structure (see fig 6). A protective layer 17 of for instance SiO₂ is then deposited on the lower first portion of the mesa structure at least to the level of the upper, second portion as illustrated in fig 7. The two upper layers highly doped of n-type and p-type are then etched away from said upper, second portion while leaving them on a mesa wall 21 (trench wall) connecting the two portions and on the lower, first portion as illustrated in fig 8. The protective layer is then removed and an n-type channel layer 4 is epitaxially grown on top of the mesa structure. After applying a mask and appropriate patterning a highly doped n-type drain region layer is formed by ion implantation in said second portion at a lateral distance to the base layer and to the source region layer, n-type dopants are also implanted through the channel layer 4 into the source region layer 5 for creating a highly doped n-type layer 18 providing a low resistance contact between the source region layer and the source contact. Finally, a gate electrode is applied on top of the channel layer as shown in fig 3 and a source contact and a drain contact on top of the source region layer and the drain region layer as shown in fig 3.

A transistor according to a second preferred embodiment of the invention is schematically illustrated in fig 10, and this differs mainly from those already described by the fact that the gate electrode 9 is separated from the channel layer by an insulation layer 19, for instance of SiO₂, AIN, silicon nitride, aluminium oxide or combinations thereof. A transistor with such a MIS structure can have better high temperature capabilities than metal-semiconductor field effect transistors as shown in fig 2 and 3 and can be used for high temperature electronic applications.

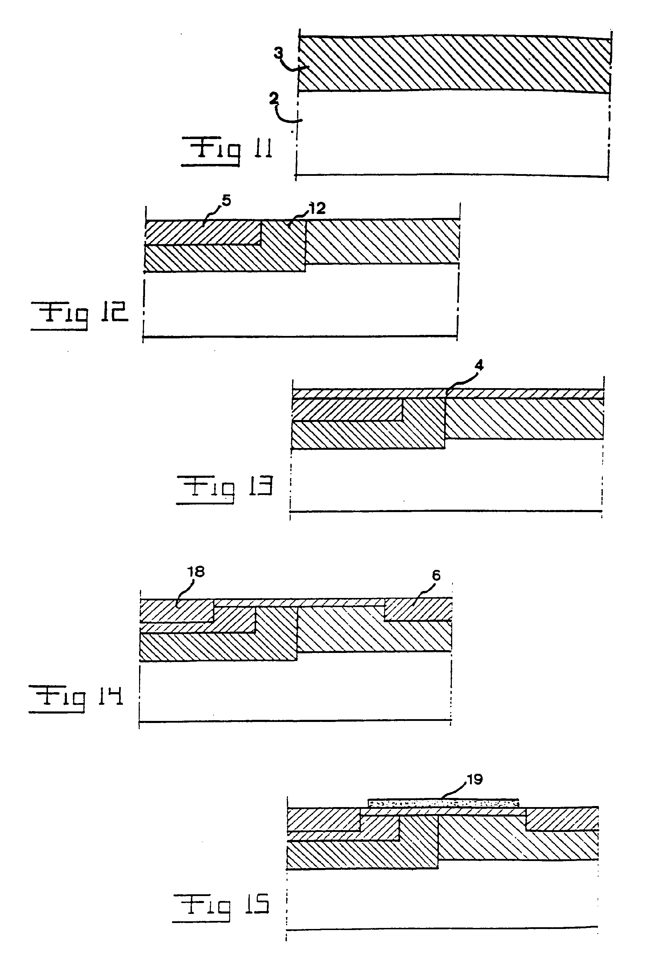

The transistor according to fig 10 may be fabricated through the sequence illustrated in fig 11-15 starting by growing a low-doped p-type buffer layer 3 onto a semi-insulating substrate 2. A p-base layer 12 and a source region layer 5 are then formed in the same way as for the embodiment of fig 3 using lateral epitaxy and planarisation. An n-type channel layer 4 is then epitaxially grown on top of the base layer and the source region layer as shown in fig 13. Highly doped source and drain contact regions 6, 18 are formed by implanting nitrogen to provide a concentration above 10¹⁸ cm⁻³. Annealing then takes place at approximately 1 700°C. The insulating layer is then deposited or grown on top of the structure and patterned to the appearance shown in fig 15. Finally, the final structure according to fig 10 is obtained by depositing the gate electrode, the source metal contact and the drain metal contact.

The extension of the highly doped base layer in the lateral direction with respect to the drain region layer and with respect to the gate electrode may be varied as long as the conditions of a lateral spacing between the drain region layer and the base layer as well as an at least partial overlap of the base layer and the gate electrode are observed.

Furthermore, it is emphasized that the mutual proportions of the different layers of the transistors as shown in the figures are only chosen for the sake of clearness and may in practice be totally different.

## Claims

1. A lateral field effect transistor of SiC for high switching frequencies comprising a source region layer (5) and a drain region layer (6) laterally spaced and highly doped n-type, an n-type channel layer (4) of lower doping concentration extending laterally and interconnecting the source region layer and the drain region layer for conducting a current between these layers in the on-state of the transistor, and a gate electrode (9) arranged to control the properties of the channel layer to be conducting or blocking through varying the potential applied to the gate electrode, the transistor further comprising a highly doped p-type base layer (12) arranged next to the channel layer at least partially overlapping the gate electrode while having portions of said channel layer (11) separating it from the gate electrode (9) and being at a lateral distance to the drain region layer by the presence of a lateral spacing between the base layer and the drain region layer, said base layer being shorted to the source region layer, **characterized in that** the source region layer (5) extends laterally under the channel layer (4) to the gate electrode (9), and that the p-type base layer extends under the source region layer to block the extension of the depleting region from the source region layer to the drain region layer.

2. A transistor according to claim 1, **characterized in that** said base layer (12) is arranged at least partially under the channel layer (4).

3. A transistor according to claim 2, **characterized in that** the gate electrode (9) is arranged over at least a part of the channel layer (4).

4. A transistor according to any of the claims 1-3, **characterized in that** the base layer (12) is totally overlapping the gate electrode (9).

5. A transistor according to any of the claims 1-4, **characterized in that** the doping concentration of said base layer (12) decreases either gradually or step-wise over at least a part of the lateral extension thereof in the lateral direction from the source region layer (5) towards the drain region layer (6).

6. A transistor according to any of the claims 1-5, **characterized in that** the doping concentration of said base layer (12) is above 10¹⁸ cm⁻³, more preferred above 10¹⁹ cm⁻³ and most preferred above 10²⁰ cm⁻³.

7. A transistor according to any of the claims 1-6, **characterized in that** said base layer (12) is doped with Al.

8. A transistor according to any of the claims 1-7, **characterized in that** it further comprises a p-type buffer layer (3) arranged so as to separate the channel layer (4) from the substrate.

9. A transistor according to any of the claims 1-8, **characterized in that** the gate electrode (9) is arranged next to the channel layer (4).

10. A transistor according to any of the claims 1-8, **characterized in that** it comprises an insulation layer (19) arranged between the gate electrode (9) and the channel layer (4).

11. A transistor according to any of the claims 1-10, **characterized in that** at least a part of the source region layer (5) is arranged next to the base layer (12) for forming a pn-junction (13) therebetween.

12. A transistor according to claim 11, **characterized in that** the source-region layer (5) and the base layer (12) are arranged to form a substantially vertical pn-junction (13) therebetween.

13. A transistor according to claim 11 or 12, **characterized in that** it comprises a trench (20), and that the base layer (12) and the source region layer (5) are arranged on top of each other as seen in the lateral direction on a substantially vertical wall (21) of the trench.

14. A transistor according to any of the claims 1-13, **characterized in that** it comprises a vertical trench (20) from above having the source region layer (5) applied at substantially vertical walls (21) thereof, and that the crystal planes of the SiC forming opposite, substantially vertical trench walls are substantially crystallographically symmetrical.

15. A transistor according to any of the claims 1-14, **characterized in that** the lateral extension of the gate electrode (9) is below 1,5µm, preferably below 0.4µm.

16. A method for producing a lateral field effect transistor of SiC, in which the channel layer (4) is epitaxially grown on top of a patterned p-type base layer (12), i.e. a base layer with a restricted lateral extension, and the method comprises the steps of:
1) epitaxially growing in the order mentioned on top of a substrate layer (2) a p-type buffer layer (3) and an n-type layer (14),
2) carrying out a mesa etch through said two layers epitaxially grown for forming a step with a lower first portion (15) with the substrate exposed and an upper second portion (16) with said n-type layer on top,
3) epitaxially growing in the order mentioned a highly doped p-type base layer (12) and a highly doped n-type source region (5) layer on top of the etched mesa structure,
4) depositing a protective layer (17) on the lower first portion of the mesa structure at least to the level of the upper, second portion,
5) etching the two upper layers highly doped of n-type and p-type away from said upper, second portion while leaving them on a mesa wall connecting the two portions and on the lower, first portion,
6) removing the protective layer and epitaxially growing an n-type channel layer (4) on top of the mesa structure,
7) applying a highly doped n-type drain region layer (6) at said second portion at a lateral distance to said base layer (12) and to said source region layer (5), i.e. while forming lateral spacings between the base layer and the drain region layer and the draing region layer and the source region layer,
8) applying a gate electrode (9) on top of the channel layer (4) at least partially overlapping said base layer, while having portions of said channel layer (11) separating the gate electrode (9) from the base layer, and a source contact (7) and a drain contact (8) on top of the source region layer and the drain region layer, respectively, so that said p-type base layer extends under! the source region layer to block the extension of the depleting region from the source region layer to the drain region layer.

17. A method according to claim 16, **characterized in that** the drain region layer (6) is applied by implanting n-type dopants into a restricted area of said second portion (16).

18. A method according to claim 16 or 17, **characterized in that** a low resistance contact between the source region layer and the source contact is established by implanting n-type dopants at a high dose into said first portion for creating a highly doped n-type layer (18) extending through the channel layer and into the source region layer after step 6).

19. A method according to any of the claims 16-18, **characterized in that** Al is used as dopants for said highly doped p-type base layer (12).

20. A method according to any of the claims 16-19, **characterized in that** said highly doped p-type base layer (12) is produced while giving it a doping concentration above 10¹⁹ cm⁻³.

21. A use of a transistor according to any of the claims 1-15 for switching high frequencies above 1 MHz, preferably above 1 GHz.

22. A use of a transistor according to any of the claims 1-15 for switching high frequency signals with a power above 1W.

23. A use of a transistor according to any of the claims 1-15 in base stations for mobile telephones.

24. A use of a transistor according to any of the claims 1-15 in radars.

25. A use of a transistor according to any of the claims 1-15 in microwave heating applications.

26. A use of a transistor according to any of the claims 1-15 in generating gas plasmas.

## Patentansprüche

1. Lateraler SiC-basierter Feldeffekttransistor für hohe Schaltfrequenzen, umfassend eine Quellbereich-Schicht (5) und eine Senkenbereich-Schicht (6), die seitlich mit Abstand angeordnet und ein hochdotierter n-Typ sind, ferner eine n-Typ-Kanalschicht (4) niedriger Dotierkonzentration, die sich in seitlicher Richtung erstreckt und die Quellbereich-Schicht sowie die Senkenbereich- Schicht verbindet, um zwischen diesen Schichten im Einschaltzustand des Transistors einen Strom zu leiten, und eine Gatterelektrode (9), die so angeordnet ist, daß sie die Eigenschaften der Kanalschicht steuert, so daß diese durch Veränderung des auf die Gatterelektrode einwirkenden Potentials leitet oder nicht leitet, wobei der Transistor des weiteren eine hochdotierte Basisschicht (12) des p-Typs aufweist, die neben der Kanalschicht angeordnet ist und dabei die Gatterelektrode wenigstens teilweise überlappt, wobei ferner Teile der Kanalschicht (11) vorhanden sind, die sie von der Gatterelektrode (9) trennen und in einem seitlichen Abstand zu der Senkenbereich-Schicht liegen, und zwar durch den vorhandenen seitlichen Abstand zwischen der Basisschicht und der Senkenschicht und wobei die Basisschicht zu der Quellbereich-Schicht verkürzt ist, **dadurch gekennzeichnet, daß** die Quellbereich-Schicht (5) sich unter der Kanalschicht (4) zu der Gatterelektrode (9) seitlich erstreckt, so daß die Basisschicht des p-Typs sich unter der Quellbereich-Schicht erstreckt, um die Ausdehnung des Randbereichs von der Quellbereich-Schicht zur Senkenbereich-Schicht zu blockieren.

2. Transistor nach Anspruch 1, **dadurch gekennzeichnet, daß** die Grundschicht (12) wenigstens teilweise unter der Kanalschicht (4) angeordnet ist.

3. Transistor nach Anspruch 2, **dadurch gekennzeichnet, daß** die Gatterelektrode (9) über wenigstens einem Teil der Kanalschicht (4) angeordnet ist.

4. Transistor nach einem der Ansprüche 1 bis 3, **dadurch gekennzeichnet, daß** die Grundschicht (12) die Gatterelektrode (9) vollständig überlappt.

5. Transistor nach einem der Ansprüche 1 bis 4, **dadurch gekennzeichnet, daß** die Dotierkonzentration der Grundschicht (12) entweder allmählich oder schrittweise über wenigstens einem Teil ihrer seitlichen Erstreckung in der seitlichen Richtung, von der Quellbereichsschicht (5) aus gegen die Senkenbereichs-Schicht (6) abnimmt.

6. Transistor nach einem der Ansprüche 1 bis 5, **dadurch gekennzeichnet, daß** die Dotierkonzentration der Grundschicht (12) über 10¹⁸ cm⁻³, vorzugsweise über 10¹⁹ cm⁻³ und insbesondere 10²⁰ cm⁻³ liegt.

7. Transistor nach einem der Ansprüche 1 bis 6, **dadurch gekennzeichnet, daß** die Grundschicht (12) mit Al dotiert ist.

8. Transistor nach einem der Ansprüche 1 bis 7, **dadurch gekennzeichnet, daß** er des weiteren eine Pufferschicht (3) des p-Typs aufweist, die so angeordnet ist, daß sie die Kanalschicht (4) von dem Substrat trennt.

9. Transistor nach einem der Ansprüche 1 bis 8, **dadurch gekennzeichnet, daß** die Gatterelektrode (9) neben der Kanalschicht (4) angeordnet ist.

10. Transistor nach einem der Ansprüche 1 bis 8, **dadurch gekennzeichnet, daß** er eine Isolierschicht (19) aufweist, die zwischen der Gatterelektrode (9) und der Kanalschicht (4) angeordnet ist.

11. Transistor nach einem der Ansprüche 1 bis 10, **dadurch gekennzeichnet, daß** wenigstens ein Teil der Quellbereich-Schicht (5) neben der Grundschicht (12) angeordnet ist, um dazwischen eine pn-Bindung (13) zu schaffen.

12. Transistor nach Anspruch 11, **dadurch gekennzeichnet, daß** die Quellbereich-Schicht (5) und die Grundschicht (12) so angeordnet sind, daß sie zwischen sich eine im wesentlichen senkrechte pn-Bindung (13) bilden.

13. Transistor nach Anspruch 11 oder 12, **dadurch gekennzeichnet, daß** er einen Graben (20) aufweist, und daß die Grundschicht (12) und die Quellbereich-Schicht (5) übereinander angeordnet sind, und zwar gesehen in seitlicher Richtung, auf einer im wesentlichen senkrechten Wand (21) des Grabens.

14. Transistor nach einem der Ansprüche 1 bis 13, **dadurch gekennzeichnet, daß** er einen senkrechten Graben (20) von oben aufweist, der eine Quellbereich-Schicht (5) besitzt, die an seinen im wesentlichen senkrechten Wänden (21) angeordnet ist, und daß die Kristallebenen des SiC die gegenüberliegend, im wesentlichen senkrechten Grabenwände bilden, im wesentlichen kristallografisch symmetrisch sind.

15. Transistor nach einem der Ansprüche 1 bis 14, **dadurch gekennzeichnet, daß** die seitliche Erstreckung der Gatterelektrode (9) kleiner als 1,5 µm, vorzugsweise kleiner als 0,4 µm ist.

16. Verfahren zur Herstellung eines lateralen SiC-basierten Feldeffekt-Transistors, bei dem die Kanalschicht (4) oben auf einer gemusterten Grundschicht (12) des p-Typs epitaxial gewachsen ist, also einer Grundsicht mit einer beschränkten seitlichen Ausdehnung, wobei das Verfahren folgende Schritte umfaßt:
1) epitaxiales Wachsen in der unten genannten Reihenfolge, nämlich oben auf einer Substratschicht (2), einer Pufferschicht (3) des p-Typs und einer n-Typ-Schicht (14);
2) Ausführen einer Mesa-Ätzung durch die beiden epitaxial gewachsenen Schichten zur Bildung einer Stufe mit einem niedrigen ersten Teil (15) mit freiliegendem Substrat und einem oberen zweiten Teil (16) mit einer n-Typ-Schicht obendrauf;
3) epitaxiales Wachsen einer hochdotierten p-Typ-Grundschicht (12) und einer hochdotierten n-Typ-Quellbereich-Schicht (5), in dieser Reihenfolge, oben auf der geätzten Mesa-Struktur;
4) Abscheiden einer Schutzschicht (17) auf dem unteren ersten Teil der Mesa-Struktur, und zwar wenigstens bis zum Niveau des oberen, zweiten Teils;
5) Ätzen der beiden hochdotierten oberen Schichten des n-Typs und p-Typs, und zwar weg von dem oberen, zweiten Teil, während die Schichten auf einer Mesa-Wand verbleiben, die die beiden Teil verbindet, sowie auf dem unteren, ersten Teil;
6) Entfernen der Schutzschicht und epitaxiales Wachsen einer n-Typ-Kanalschicht (4) oben auf der Mesa-Struktur;
7) Anbringen einer hochdotierten Quellbereich-Schicht (6) des n-Typs an dem zweiten Teil, in einer seitlichen Entfernung zu der Grundschicht (12) und zu der Quellbereich-Schicht (5), d. h. während der Bildung von seitlichen Abständen zwischen der Grundschicht und der Senkenbereich-Schicht sowie der Senkenbereich-Schicht und der Quellbereich-Schicht;
8) Anbringen einer Gatterelektrode (9) oben auf der Kanalschicht (4), die wenigstens teilweise die Grundschicht überlappt, während Teile der Kanalschicht (11) die Gatterelektrode (9) von der Grundschicht trennen sowie eines Quellkontakts (7) und eines Senkenkontakts (8) oben auf der Quellbereich-Schicht bzw. der Senkenbereich-Schicht, so daß sich die Grundschicht des p-Typs unter der Quellbereich-Schicht erstreckt, um **dadurch** die Ausdehnung des Verarmungsbereiches von der Quellbereich-Schicht zu der Senkenbereich-Schicht zu blockieren.

17. Verfahren nach Anspruch 16, **dadurch gekennzeichnet, daß** die Senkenbereich-Schicht (6) durch Implantieren von n-Typ-Dotiersubstanzen in einen beschränkten Bereich des zweiten Teils (16) angebracht wird.

18. Verfahren nach Anspruch 16 oder 17, **dadurch gekennzeichnet, daß** zwischen der Quellbereich-Schicht und dem Quellkontakt ein Kontakt geringen Widerstands **dadurch** hergestellt wird, daß n-Dotiersubstanzen in einer hohen Dosis in den ersten Teil implantiert werden, um **dadurch** eine hochdotierte n-Typ-Schicht (18) zu erzeugen, die sich durch die Kanalschicht hindurch und in die Quellbereich-Schicht gemäß Schritt 6 hinein erstreckt.

19. Verfahren nach einem der Ansprüche 16 bis 18, **dadurch gekennzeichnet, daß** Al als Dotiersubstanz für die hochdotierte p-Typ-Grundschicht (12) verwendet wird.

20. Verfahren nach einem der Ansprüche 16 bis 19, **dadurch gekennzeichnet, daß** die hochdotierte p-Typ-Grundschicht (12) hergestellt wird, indem ihr eine Doping-Konzentration von über 10¹² cm⁻³ gegeben wird.

21. Verwendung eines Transistors gemäß einem der Ansprüche 1 bis 15 zum Schalten von Hochfrequenzen über 1 MHz, vorzugsweise über 1 GHz.

22. Verwendung eines Transistors gemäß einem der Ansprüche 1 bis 15 zum Schalten von hochfrequenten Signalen mit einer Spannung von über 1 W.

23. Verwendung eines Transistors gemäß einem der Ansprüche 1 bis 15 in Basisstationen für mobile Telefone.

24. Verwendung eines Transistors gemäß einem der Ansprüche 1 bis 15 in Radargeräten.

25. Verwendung eines Transistors gemäß einem der Ansprüche 1 bis 15 in Mikrowellen-Heizgeräten.

26. Verwendung eines Transistors gemäß einem der Ansprüche 1 bis 15 zur Erzeugung von Gasplasmen.

## Revendications

1. Transistor de SiC à effet de champ latéral pour fréquences à commutation élevée composé d'une couche de région source (5) et d'une couche de région drain (6) séparées latéralement et à dopage de type N élevé, d'une couche canal de type N (4) à dopage de concentration plus basse s'étendant latéralement et interconnectant la couche de région source et la couche de région drain pour conduire du courant entre ces couches dans l'état passant du transistor, et d'une électrode grille (9) disposée de manière à contrôleur les propriétés de la couche canal afin qu'elle soit conductrice ou isolante en fonction des variations du potentiel appliqué à l'électrode grille, le transistor comprenant de plus une couche de base à dopage de type P élevé (12) disposée à côté de la couche canal recouvrant au moins partiellement l'électrode grille tout en étant séparée de l'électrode grille (9) par des parties de la dite couche canal (11) et étant séparée latéralement de la couche de région drain par la présence d'un écartement latéral entre la couche de base et la couche de région source, la dite couche de base étant court-circuitée à la couche de région source, **caractérisé en ce que** la couche de région source (5) s'étend latéralement sous la couche canal (4) jusqu'à l'électrode grille (9), et **en ce que** la couche de base de type P s'étend sous la couche de région source pour bloquer l'extension de la région de déperdition de la couche de région source à la couche de région drain.

2. Transistor selon la revendication 1, **caractérisé en ce que** la dite couche de base (12) est placée au moins partiellement sous la couche canal (4).

3. Transistor selon la revendication 2, **caractérisé en ce que** l'électrode grille (9) est placée au-dessus d'au moins une partie de la couche canal (4).

4. Transistor selon l'une quelconque des revendications 1 à 3, **caractérisé en ce que** la couche de base (12) recouvre totalement l'électrode grille (9).

5. Transistor selon l'une quelconque des revendications 1 à 4, **caractérisé en ce que** la concentration de dopage de la dite couche de base (12) diminue soit graduellement soit par paliers sur au moins une partie de son extension latérale dans la direction latérale entre la couche de région source (5) et la couche de région drain (6).

6. Transistor selon l'une quelconque des revendications 1 à 5, **caractérisé en ce que** la concentration de dopage de la dite couche de base (12) est supérieure à 10¹⁸ cm⁻³, de préférence supérieure à 10¹⁹ cm⁻³ et de préférence supérieure à 10²⁰ cm⁻³.

7. Transistor selon l'une quelconque des revendications 1 à 6, **caractérisé en ce que** la dite couche de base (12) est dopée avec de l'A1.

8. Transistor selon l'une quelconque des revendications 1 à 7, **caractérisé en ce qu'**il comprend en outre une couche tampon de type P (3) disposée de façon à séparer la couche canal (4) du substrat.

9. Transistor selon l'une quelconque des revendications 1 à 8, **caractérisé en ce que** l'électrode grille (9) est placée à côté de la couche canal (4).

10. Transistor selon l'une quelconque des revendications 1 à 8, **caractérisé en ce qu'**il comprend une couche d'isolation (19) placée entre l'électrode grille (9) et la couche canal (4).

11. Transistor selon l'une quelconque des revendications 1 à 10, **caractérisé en ce qu'**au moins une partie de la couche de région source (5) est placée à côté de la couche de base (12) pour former entre elles une jonction PN (13).

12. Transistor selon la revendication 11, **caractérisé en ce que** la couche de la région source (5) et la couche de base (12) sont disposées de manière à former entre elles une jonction PN (13) essentiellement verticale.

13. Transistor selon la revendication 11 ou 12, **caractérisé en ce qu'**il comprend une tranchée (20), et **en ce que** la couche de base (12) et la couche de région source (5) sont disposées l'une sur l'autre dans la direction latérale sur une paroi essentiellement verticale (21) de la tranchée.

14. Transistor selon l'une quelconque des revendications 1 à 13, **caractérisé en ce qu'**il comprend une tranchée verticale (20) depuis le sommet ayant la couche de la région source (5) appliquée à ses parois essentiellement verticales (21), et **en ce que** les plans cristallins de SiC formant les parois opposées essentiellement verticales sont essentiellement cristallographiquement symétriques.

15. Transistor selon l'une quelconque des revendications 1 à 14, **caractérisé en ce que** l'extension latérale de l'électrode grille (9) est inférieure à 1,5µm, de préférence inférieure à 0,4µm.

16. Méthode de production d'un transistor de SiC à effet de champ latéral, dans laquelle on fait pousser épitaxialement la couche canal (4) sur une couche de base modelée de type P (12), c'est à dire une couche de base avec une extension latérale restreinte, et la méthode comprend les étapes de :
1) faire pousser épitaxialement dans l'ordre mentionné sur une couche de substrat (2) une couche de tampon de type P (3) et une couche de type N (14),
2) réaliser une gravure en mesa à travers deux couches poussées épitaxialement pour former une marche avec une première partie (15) inférieure ayant le substrat exposé et une seconde partie supérieure (16) ayant la dite couche de type N par dessus,
3) faire pousser épitaxialement dans l'ordre mentionné une couche de base à dopage de type P élevé (12) et une couche de région source (5) à dopage de type N élevé sur la structure gravée en mesa,
4) déposer une couche protectrice (17) sur la première partie inférieure de la structure en mesa au moins au niveau de la deuxième partie supérieure,
5) enlever par gravure les deux couches supérieures à dopages élevés de type N et de type P de la dite deuxième partie supérieure tout en les laissant sur une paroi de la mesa connectant les deux parties et sur la première partie inférieure,
6) retirer la couche protectrice et faire pousser épitaxialement une couche canal de type N (4) sur la structure en mesa,
7) appliquer une couche de région de drain (6) hautement dopée sur la dite deuxième partie à une distance latérale de la dite couche de base (12) et de la dite couche de région source (5), c'est à dire tout en formant des séparations latérales entre la couche de base et la couche de région drain et entre la région drain et la couche de région source,
8) appliquer une électrode grille (9) sur la couche canal (4) qui recouvre au moins partiellement la dite couche de base, tout en ayant des parties de la dite couche canal (11) qui séparent l'électrode grille (9) de la couche de base, et un contact de source (7) et un contact de drain (8) sur la couche de région source et la couche de région drain, respectivement, si bien que la dite couche de base de type P s'étend sous la couche de région source pour bloquer l'extension de la région de déperdition entre la couche de région source et la couche de région drain.

17. Méthode selon la revendication 16, **caractérisée en ce que** la couche de région drain (6) est appliquée en implantant des dopants de type N dans une zone restreinte de la dite deuxième partie (16).

18. Méthode selon la revendication 16 ou 17, **caractérisée en ce qu'**un contact à basse résistance entre la couche de région source et le contact de source est établi en implantant des dopants de type N à haute dose dans la dite première partie pour créer une couche de type N hautement dopée (18) s'étendant à travers la couche canal et dans la couche de région source après l'étape 6).

19. Méthode selon l'une quelconque des revendications 16 à 18, **caractérisée en ce que** de l'Al est utilisé comme dopant pour la dite couche de base de type P hautement dopée (12).

20. Méthode selon l'une quelconque des revendications 16 à 19, **caractérisée en ce que** la dite couche de base de type P hautement dopée (12) est produite tout en lui donnant une concentration de dopage supérieure à 10¹⁹ cm⁻³.

21. Utilisation d'un transistor selon l'une quelconque des revendications 1 à 15 pour inverser des hautes fréquences supérieures à 1 MHz, de préférence supérieures à 1 GHz.

22. Utilisation d'un transistor selon l'une quelconque des revendications 1 à 15 pour inverser des signaux à haute fréquence avec une tension supérieure à 1 W.

23. Utilisation d'un transistor selon l'une quelconque des revendications 1 à 15 dans des stations de base pour téléphones sans fil.

24. Utilisation d'un transistor selon l'une quelconque des revendications 1 à 15 dans les radars.

25. Utilisation d'un transistor selon l'une quelconque des revendications 1 à 15 dans des applications de chauffage au micro-ondes.

26. Utilisation d'un transistor selon l'une quelconque des revendications 1 à 15 dans la générations de plasmas gazeux.
